# EUROPÄISCHE PATENTSCHRIFT

(11) **EP 1 127 280 B1**
(45) Veröffentlichungstag und Bekanntmachung des Hinweises auf die Patenterteilung: **15.02.2006**
(21) Anmeldenummer: 00931193.7
(22) Anmeldetag: 11.05.2000
(51) Int. Cl.: G01R 31/36

(54) **ELEKTRONISCHE ÜBERWACHUNGSEINRICHTUNG FÜR MEHRTEILIGEN ELEKTRISCHEN ENERGIESPEICHER**
ELECTRONIC MONITORING DEVICE FOR A MULTIPART ELECTRICAL ENERGY STORAGE UNIT
DISPOSITIF ELECTRONIQUE DE SUIVI D'UN ACCUMULATEUR D'ENERGIE ELECTRIQUE A PLUSIEURS PARTIES

(30) Priorität: 11.05.1999 DE 19921675
(43) Veröffentlichungstag der Anmeldung: 29.08.2001
(60) Teilanmeldung: 05016523.2
(73) Patentinhaber: DaimlerChrysler AG, 70567 Stuttgart (DE)
(72) Erfinder: BULLING, Markus, D-88400 Biberach (DE); HORNUNG, Hans-Georg, D-86875 Waal (DE); WALTER, Markus, D-72555 Metzingen (DE)
(86) Internationale Anmeldenummer: PCT/EP2000/004273
(87) Internationale Veröffentlichungsnummer: WO 2000/068700

(56) Entgegenhaltungen:
- US-A- 5 099 211
- US-A- 5 578 927
- US-A- 5 760 587

## Beschreibung

Die Erfindung bezieht sich auf eine elektronische Überwachungseinrichtung für einen aus mehreren hintereinander geschalteten Speichereinheiten bestehenden elektrischen Energiespeicher, insbesondere für eine Mehrzellen- oder Mehrblock-Batterie, wobei die Überwachungseinrichtung eine entsprechende Anzahl von Messmodulen beinhaltet, die jeweils einer der Speichereinheiten zugeordnet sind und wenigstens eine speicherzustandsindikative Messgröße an der zugeordneten Speichereinheit messen. Der Einfachkeit halber sollen vorliegend unter dem Begriff "elektrischer Energiespeicher" neben bloßen Speichern, wie Batterien, auch Energieerzeuger verstanden werden, die aus nicht-elektrischer, gespeicherter Energie, z.B. mechanischer oder chemischer Energie, elektrische Energie erzeugen, z.B. Brennstoffzellensysteme.

Derartige Überwachungseinrichtungen dienen zur Überwachung des Zustands der einzelnen Blöcke oder Zellen des elektrischen Energiespeichers, wie einer Traktionsbatterie eines Kraftfahrzeugs mit Elektro- oder Hybridantrieb oder eines Brennstoffzellenstapels z.B. in einem Brennstoffzellenfahrzeug. Typische überwachte, für den Speicherzustand indikative Messgrößen sind insbesondere die von der jeweiligen Speichereinheit bereitgestellte elektrische Spannung sowie die Temperatur und der Druck in der Speichereinheit. Die Überwachung dient unter anderem der Feststellung unterschiedlicher Ladezustände der Speichereinheiten aufgrund ungleichmäßiger Selbstentladung und Alterung der seriell geschalteten Speichereinheiten, so dass gegebenenfalls geeignete Gegenmaßnahmen ergriffen werden können, z.B. ein Ladungstransfer zwischen Speichereinheiten, um deren Ladezustand auf annähernd gleichem Niveau zu halten und so zu vermeiden, dass die Gesamtkapazität des elektrischen Energiespeichers von der "schlechtesten" Speichereinheit bestimmt wird.

Eine Überwachungseinrichtung der eingangs genannten Art ist in der Patentschrift DE 195 03 917 C2 beschrieben. Bei der dortigen Einrichtung sind die einzelnen Messmodule an einen als Ring ausgelegten, seriellen Datenbus angeschlossen, an den auch eine zentrale Datenverarbeitungseinheit angekoppelt ist. Die Messdateninformationen werden von Messmodul zu Messmodul in Form von Messdatenpaketen über den Ring geleitet, wobei jedes Messmodul von jedem Messdatenpaket die von ihm benötigten Informationen entnimmt und dem Messdatenpaket seine eigenen Messdaten, z.B. über Spannung und Temperatur der zugehörigen Speichereinheit, hinzufügt. Die zentrale Datenverarbeitungseinheit kann die Messdaten zur Bestimmung des Zustands der einzelnen Speichereinheiten und damit des gesamten elektrischen Energiespeichers auswerten.

Bei einem weiteren Typ gattungsgemäßer Batterieüberwachungseinrichtungen sind die den einzelnen Speichereinheiten zugeordneten Messmodule parallel an eine gemeinsame Signalverbindung angekoppelt. Bei einer in der Offenlegungsschrift EP 0 277 321 A1 beschriebenen derartigen Einrichtung übertragen die Messmodule nacheinander nach Aufruf ihre Messdaten zu einer zentralen Auswerteeinheit.

Der Erfindung liegt als technisches Problem die Bereitstellung einer elektronischen Überwachungseinrichtung der eingangs genannten Art zugrunde, die vergleichsweise wenig Verkabelungs- und Steuerungsaufwand erfordert und zuverlässige Aussagen über den Zustand des Energiespeichers anhand der Erfassung einer oder mehrerer entsprechender Messgrößen ermöglicht.

Die Erfindung löst dieses Problem durch die Bereitstellung einer elektronischen Überwachungseinrichtung mit den Merkmalen des Anspruchs 1 oder 2. Die erfindungsgemäße Überwachungseinrichtung erfordert relativ wenig Verkabelungsaufwand und erlaubt mindestens die Bestimmung von im allgemeinen besonders interessierenden, für den Zustand des elektrischen Energiespeichers indikativen Extremalwerten des oder der verwendeten Messgrößen.

Die Überwachungseinrichtung nach Anspruch 1 zeichnet sich speziell dadurch aus, dass die Messgrößeninformation sukzessive von einem zum nächsten Messmodul weitergegeben und vom jeweils nächsten Messmodul dadurch neu bestimmt wird, dass dessen an der zugehörigen Speichereinheit gewonnener Messgrößenwert mit der empfangenen Messgrößeninformation anhand eines oder mehrerer vorgebbarer Bewertungskriterien bewertet wird. Im Fall eines Extremalwert-Bewertungskriteriums besteht diese Bewertung in der Überprüfung, ob der eigene Messgrößenwert größer oder kleiner als der in der empfangenen Messgrößeninformation enthaltene, bisherige Extremalwert ist, um dann den dergestalt neu bestimmten Extremalwert als eigene Messgrößeninformation an das nächste Messmodul weiterzugeben. Die Messmodule brauchen nicht auf Spannungsfestigkeit ausgelegt sein.

In einer Weiterbildung der Erfindung nach Anspruch 2 sind die Messmodule durch Betriebsmodus-Steuersignale zwischen einem aktivierten und einem deaktivierten Zustand umschaltbar, wobei ihr Stromverbrauch im deaktivierten Zustand minimiert ist. Die Steuersignale können je nach Systemvariante den Messmodulen auf einer gemeinsamen Signalleitung parallel zugeführt oder sequentiell von einem zum nächsten Messmodul weitergereicht werden. Mit Hilfe dieser Betriebsmodus-Steuersignale können die momentan jeweils nicht benötigten Messmodule energiesparend im deaktivierten Zustand gehalten werden.

In einer Weiterbildung der Erfindung nach Anspruch 3 sind die Messmodule durch Bewertungsmodus-Steuersignale zwischen verschiedenen Bewertungsmodi umschaltbar, z.B. zwischen einer Bewertung hinsichtlich Maximum oder Minimum einer jeweiligen Messgröße oder zwischen Bewertungen unterschiedlicher Messgrößen- Dadurch können diese verschiedenen Messgrößeninformationen zu unterschiedlichen Zeiten auf derselben Signalleitung bereitgestellt werden.

In einer Weiterbildung der Erfindung nach Anspruch 4 können die Messmodule selektiv in aktive und passive Messmodule unterteilt werden, wobei unter aktiven Messmodulen solche mit voll aktiviertem Funktionsumfang und unter passiven Messmodulen solche zu verstehen sind, die so weit in Bereitschaft gehalten sind, dass sie empfangene Signale weiterleiten können, z.B. die von einem benachbarten Messmodul übertragene Messgrößeninformation, jedoch keine Änderung solcher bloß weitergeleiteter Signale aufgrund eigener Messwerte vornehmen. Damit lassen sich bei der Systemvariante mit sequentieller Weiterleitung und Bewertung der Messgrößeninformation beliebige Messmodule auswählen, die an der Gewinnung der bewerteten Messgrößeninformation aktiv teilnehmen.

In einer Weiterbildung der Erfindung nach Anspruch 5 wird das Messsignal in Form eines pulsweitenmodulierten Signals, dessen Pulsbreite den zugehörigen Messgrößenwert repräsentiert, von den Messmodulen abgegeben. Dies ermöglicht sehr einfache Extremalwertbestimmungen im Rahmen eines entsprechenden Extremalwert-Bewertungskriteriums und vermeidet Fehleradditionen bei einem seriellen Weiterreichen der Messgrößeninformation von Messmodul zu Messmodul. Alternativ ist in einer Weiterbildung der Erfindung nach Anspruch 6 eine Messsignalkonditionierung dergestalt vorgesehen, dass das jeweilige Messsignal aus einem Puls besteht, der um eine vom jeweiligen Messwert abhängige Zeitspanne verzögert gesendet wird. Auch dieser Messsignaltyp erlaubt sehr einfache Extremalwertbestimmungen. Weiter alternativ ist in einer Weiterbildung der Erfindung nach Anspruch 7 das Messsignal als ein Konstantstromsignal konditioniert, das ebenfalls eine einfache Extremalwertbestimmung ermöglicht.

In einer weiteren Ausgestaltung der Erfindung ermöglicht die Überwachungseinrichtung gemäß Anspruch 8 eine dissipative Ladezustandsangleichung, indem die Messmodule jeweils einen elektrischen Widerstand enthalten, über den Speichereinheiten mit zu hohem detektiertem Ladezustand so weit entladen werden können, dass der maximale Ladezustandsunterschied zwischen den Speichereinheiten einen vorgebbaren Toleranzwert nicht überschreitet.

Bevorzugte Ausführungsformen der Erfindung werden nachfolgend unter Bezugnahme auf die Zeichnungen beschrieben, in denen zeigen:
- Fig. 1: ein Blockschaltbild einer mehrzelligen Batterie mit zugeordneter elektronischer Überwachungseinrichtung mit seriell verschalteten Messmodulen, und
- Fig. 2: eine schematische Darstellung von Triggersignalen und Spannungsmesssignalen zur Erläuterung der Betriebsweise der Überwachungseinrichtung von Fig. 1.

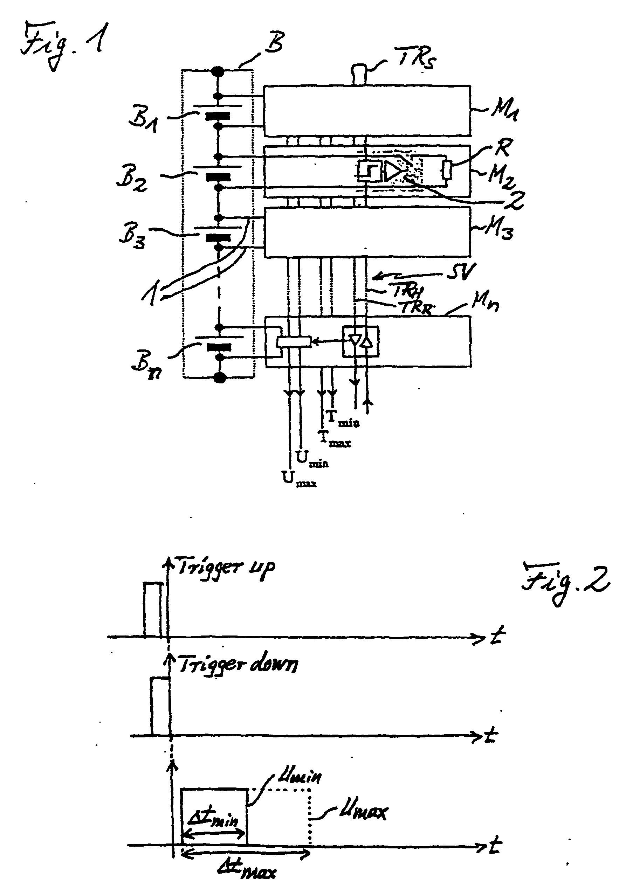

Fig. 1 zeigt schematisch eine aus mehreren, seriell hintereinandergeschalteten Einzelzellen B₁, B₂, ..., Bₙ bestehende Batterie B, die beispielsweise als Traktionsbatterie in einem Elektrofahrzeug oder einem Fahrzeug mit Hybridantrieb dienen kann. Jeder Batteriezelle B₁, ..., Bₙ ist ein Messmodul M₁, ..., Mₙ zugeordnet. Jedes Messmodul M₁, ..., Mₙ sensiert einen oder mehrere, für den Speicherzustand seiner zugeordneten Batteriezelle indikative Messgrößen, wie Spannung, Temperatur und Druck, wozu es über entsprechende Messleitungen 1 mit diesem verbunden ist.

Die Messmodule M₁, ..., Mₙ sind untereinander über eine serielle Signalverbindung SV miteinander verbunden, wobei die serielle Signalverbindung SV im gezeigten Beispiel ein Triggerleitungspaar TR_{H}, TR_{R}, ein Spannungssignalleitungspaar SPₘᵢₙ, SPₘₐₓ und ein Temperatursignalleitungspaar TEₘᵢₙ, TEₘₐₓ umfasst. Das Triggerleitungspaar besteht aus einer Triggersignal-Hinleitung TR_{H}, über die ein Triggersignal sukzessive vom letzten Messmodul Mₙ bis zum ersten Messmodul M₁ geleitet wird, und einer Triggersignal-Rückleitung TR_{R}, die am ersten Messmodul M₁ mit der Hinleitung TR_{H} verbunden ist, wie mit einer Leitungsschleife TR_{S} symbolisiert, und von dort bis zum letzten Messmodul Mₙ zurückführt. An das Triggerleitungspaar TR_{H}, TR_{R} ist in jedem Messmodul M₁, ..., Mₙ eine zugehörige Triggerschaltung herkömmlicher Art angekoppelt, die bei Empfang eines entsprechenden Triggersignals das Messmodul dazu aktiviert, einen Mess- und Bewertungsvorgang durchzuführen.

Im gezeigten Beispiel sind die Messmodule M₁, ..., Mₙ, zur Durchführung der Mess- und Bewertungsvorgänge derart ausgelegt, dass der Maximalwert und der Minimalwert der Spannungen und der Temperaturen der einzelnen Batteriezellen B₁. ..., Bₙ ermittelt werden können. Die auf diese Weise ermittelten vier Extremalwerte stehen auf den entsprechenden Signalleitungen am zugehörigen Ausgang des ersten Messmoduls M₁ an, d.h. der minimale Spannungswert Uₘᵢₙ an der Spannungssignalleitung SPₘᵢₙ, der maximale Spannungswert Uₘₐₓ auf der Spannungssignalleitung SPₘₐₓ, der minimale Temperaturwert Tₘᵢₙ auf der Temperatursignalleitung TEₘᵢₙ und der maximale Temperaturwert Tₘₐₓ auf der Temperatursignalleitung TEₘₐₓ. In alternativen Systemauslegungen kann die Bestimmung nur eines Teils dieser vier Extremalwerte und/oder die zusätzliche Ermittlung entsprechender Extremalwerte für den Druck in der jeweiligen Batteriezelle vorgesehen sein. Je nach den verwendeten Bewertungskriterien können statt oder zusätzlich zu solchen Extremalwerten auch andere, für den Speicherzustand der einzelnen Batteriezellen B₁, ..., Bₙ indikative Parameter über die Messmodulkette M₁, ..., Mₙ überwacht, d.h. von den Messmodulen M₁, ..., Mₙ entsprechende Messgrößeninformationen geliefert werden.

Die Ermittlung der Extremalwerte erfolgt mittels sukzessiver Gewinnung der Messwerte für Spannung und Temperatur der jeweiligen Batteriezelle B₁, ..., Bₙ durch das zugehörige Messmodul M₁, ..., Mₙ, geeigneter Bewertung der eigenen Messwerte mit der von einem vorhergehenden Messmodul empfangenen Spannungs- bzw. Temperaturinformation und Weiterleitung der bewerteten Spannungs- bzw. Temperaturinformation zum nächsten Messmodul. Im einzelnen ist dazu folgende Vorgehensweise in den Messmodulen M₁, ..., Mₙ implementiert. Zunächst wird beispielsweise von einer nicht gezeigten Überwachungssteuereinheit ein Triggersignal "Trigger up", wie es im obersten Diagramm von Fig. 2 gezeigt ist, vom letzten Messmodul Mₙ bis zum ersten Messmodul M₂ geleitet, von wo es als Rücksignal "Trigger down" wieder zum letzten Messmodul Mₙ zurückläuft und dabei erst beim Rücklauf den Messvorgang im jeweiligen Messmodul auslöst. Dadurch beginnt in einem Messzyklus das erste Messmodul M₁ mit der Erfassung von Spannung und Temperatur der ersten Batteriezelle B₁. Es leitet diese Information dann sowohl als minimalen wie auch als maximalen Spannungswert bzw. Temperaturwert an das zweite Messmodul M₂ weiter. Das zweite Messmodul M₂ empfängt diese Messgrößeninformation und misst seinerseits Spannung und Temperatur der zweiten Batteriezelle B₂. Anschließend nimmt es eine Bewertung für beide Messgrößen vor, indem es feststellt, ob die selbst gemessene Spannung der zweiten Batteriezelle B₂ kleiner oder größer als der ihm zugeführte Spannungswert für die erste Batteriezelle B₁ ist. Es gibt dann den kleineren Spannungswert als den Spannungsminimalwert Uₘᵢₙ und den größeren Spannungswert als den Spannungsmaximalwert Uₘₐₓ an das dritte Messmodul M₃ weiter. Analog verfährt es mit der Temperatur als der zweiten Messgröße.

Das dritte Messmodul M₃ misst seinerseits Spannung und Temperatur der dritten Batteriezelle B₃ und vergleicht den selbstgemessenen Spannungswert einerseits mit dem ihm zugeführten bisherigen minimalen Spannungswert Uₘᵢₙ und andererseits mit dem ihm zugeführten bisherigen maximalen Spannungswert Uₘₐₓ. Vom erstgenannten Minimalwertvergleich gibt es den kleineren Wert als aktuellen minimalen Spannungswert an das nächste Messmodul weiter, vom letztgenannten Maximalwertvergleich gibt es den größeren Wert als aktuellen maximalen Spannungswert an das nächste Messmodul weiter. Ebenso verfährt es mit der anderen Messgröße, der Temperatur. Auf diese Weise werden die vier Extremalwertinformationen Uₘᵢₙ, Uₘₐₓ, Tₘᵢₙ, Tₘₐₓ vom jeweils vorherigen Messmodul empfangen, mit den eigenen Messwerten entsprechend bewertet und als solchermaßen aktualisierte Messgrößeninformationen zum nächsten Messmodul weitergeleitet, bis schließlich das letzte Messmodul Mₙ die für die Gesamtheit der einzelnen Batteriezellen B₁, ..., Bₙ gültigen Spannungs- und Temperaturextremalwerte Uₘᵢₙ, Uₘₐₓ, Tₘᵢₙ, Tₘₐₓ abgibt, um sie z.B. der Überwachungssteuereinheit zuzuführen.

Indem die Triggerung der Messmodule M₁, ..., Mₙ, wie beschrieben, erst mit dem rücklaufenden Triggersignal "Trigger down" erfolgt und so zuerst das von der Einspeisestelle des Triggersignals, d.h. dem letzten Messmodul Mₙ der Messmodulkette, am weitesten entfernte Messmodul, d.h. das erste Messmodul M₁, getriggert wird, wird eine vorteilhafte Kompensation der Triggersignallaufzeit erreicht, die sich in der zeitlichen Verzögerung des im mittleren Diagramm von Fig. 2 dargestellten, zurückgelaufenen Triggersignals "Trigger down" gegenüber dem eingespeisten Triggersignal "Trigger up" widerspiegelt. Alternativ kann eine solche Kompensation der Triggersignallaufzeit auch dadurch erreicht werden, dass die Messmodule M₁, ..., Mₙ bereits mit dem eingespeisten Triggersignal "Trigger up" aktiviert werden, die Spannungs- und Temperaturmessinformationen dann aber am zuletzt getriggerten Messmodul am der Triggersignaleinspeisestelle gegenüberliegenden Ende der Messmodulkette abgenommen werden.

Eine einfache Extremalwertbewertung der Messsignalinformationen lässt sich bei Verwendung von pulsweitenmodulierten Messsignalen erreichen, deren Pulsweite den zugehörigen Messwert repräsentiert. Dies ist für das Spannungssignal im unteren Diagramm von Fig. 2 veranschaulicht. Dort ist dementsprechend das Spannungsminimalwertsignal mit durchgezogener Linie in einer Pulsbreite Δtₘᵢₙ gezeigt, die den minimalen Spannungswert Uₘᵢₙ repräsentiert. In gleicher Weise ist das Spannungsmaximalwertsignal mit gepunkteter Linie in einer Breite Δtₘₐₓ gezeigt, die den maximalen Spannungswert Uₘₐₓ repräsentiert. Die Minimalwert-Bewertung kann dann im jeweiligen Messmodul durch einfache UND-Verknüpfung des eigenen Messwertes mit dem vom vorigen Messmodul zugeführten, bislang geltenden Minimalwert erfolgen, deren Resultat den neu geltenden Minimalwert darstellt, d.h. es wird das schmalere der beiden verglichenen Signale ausgewählt. In gleicher Weise kann die Maximalwert-Bewertung durch einfache ODER-Verknüpfung des eigenen Messwertes mit dem zugeführten, bislang geltenden Maximalwert realisiert sein, d.h. es wird das jeweils breitere der beiden verglichenen Signale ausgewählt.

Die Messgeschwindigkeit für einen Messzyklus ist bei Verwendung solcher pulsweitenmodulierter Messsignale primär abhängig vom Produkt der maximal auftretenden Pulsbreite mit der Modulanzahl n. Durch die Verwendung von pulsweitenmodulierten Messsignalen lässt sich eine Fehleraddition beim Weiterleiten der Messgrößeninformationen vom einen zum nächsten Messmodul vermeiden, es addieren sich lediglich Laufzeitdifferenzen.

Alternativ zur beschriebenen Verwendung pulsweitenmodulierter Messsignale können die Messwertinfortnationen auch einfach als analoge Messgrößeninformationen, insbesondere über Extremalwerte der betrachteten Messgrößen, in der Messmodulkette weitergeleitet und bewertet werden. In diesem Fall ist kein Triggersignal nötig, vielmehr kann quasi-parallel gemessen werden, und die Messwertinformationen können seriell bewertet und weitergeleitet werden. Unabhängig von der Konfiguration der Messgrößeninformationen besteht ein allgemeiner Vorteil der seriellen Verknüpfung der Messmodule M₁, ..., Mₙ über die serielle Signalverbindung SV darin, dass die Messmodule M₁, ..., Mₙ nicht spannungsfest ausgelegt sein müssen.

Eine weitere alternative Möglichkeit der Konfiguration der bewerteten und weitergeleiteten Messgrößeninformationen besteht darin, als Messsignal einen Puls mit konstanter Impulsbreite zu verwenden, der zu einem vom zu kodierenden Messwert abhängigen Zeitpunkt erzeugt wird, d.h. um eine vom Messwert abhängige Zeitspanne gegenüber einem Referenzzeitpunkt verzögert. Diese Variante erlaubt die Übertragung sowohl eines Maximalwertes als auch eines Minimalwertes auf einer gemeinsamen Übertragungsleitung ohne codiertes Triggersignal, in dem z.B. der Minimalwert dem frühesten Puls und der Maximalwert dem spätesten Puls entspricht und zwischenliegende Pulse jeweils nicht weitergeleitet werden. Es genügt dann ein jeweiliger ODER-Vergleich zwischen dem eigenen Messsignal mit dem empfangenen frühesten bzw. dem empfangenen spätesten Puls zur Bewertung hinsichtlich Minimalwert und Maximalwert der jeweiligen Messgröße, wie Spannung, Temperatur oder Druck. Es ist lediglich für einen Abgleich der konstanten Pulsbreite zwischen den Messmodulen, M₁, ... , Mₙ zu sorgen.

Soweit die verwendete Messsignalkonfiguration eine Messwertcodierung durch digitale Signale beinhaltet, versteht sich, dass die Messmodule M₁, ..., Mₙ jeweils einen entsprechenden A/D-Wandler enthalten und im Signalauswerteteil der Überwachungseinrichtung eine geeignete herkömmliche digitale Signalverarbeitung implementiert ist.

Zu der in Fig. 1 gezeigten und oben beschriebenen Überwachungseinrichtung sind verschiedene vorteilhafte Modifikationen möglich. So kann z.B. auf dem Triggerleitungspaar TR_{H}, TR_{R} oder einer eigenständigen seriellen Steuersignalverbindung die sukzessive Weiterleitung eines Betriebsmodus-Steuersignals über die Messmodulkette hinweg vorgesehen sein, mit welchem die Messmodule M₁, ..., Mₙ zwischen einem aktivierten Zustand, in welchem sie die beschriebenen Mess- und Bewertungsvorgänge ausführen können, und einem deaktivierten, abgeschalteten Zustand umschaltbar sind, in welchem sie keinen oder einen allenfalls sehr geringen Ruhestrom verbrauchen, so dass insgesamt der Stromverbrauch minimiert wird. Bevorzugt wird dabei jedes Messmodul M₁, ..., Mₙ von der zugehörigen Batteriezelle B₁, ..., Bₙ versorgt.

In einer weiteren Variante kann die Weiterleitung eines Bewertungsmodus-Steuersignals vorgesehen sein, mit welchem die Messmodule M₁, ..., Mₙ zwischen verschiedenen Bewertungsmodi umgeschaltet werden können, beispielsweise zwischen einer Bewertung auf maximale Spannung während Ladevorgängen und einer Bewertung auf minimale Spannung während Entladevorgängen oder abwechselnd zwischen einer Druck- und einer Temperaturbewertung oder zwischen beliebigen anderen möglichen Bewertungsarten. Es genügt dann gegebenenfalls eine einzige Messsignalleitung, über welche die zum jeweils aktiven Bewertungsmodus gehörige Messgrößeninformation übertragen wird. Als weitere Modifikation kann die Durchleitung eines Selektions-Steuersignals durch die Messmodulkette hindurch vorgesehen sein, mit welchem die dazu entsprechend ausgelegten Messmodule M₁, ..., Mₙ zwischen einem aktiv bewertenden Zustand und einem passiv bleibenden, bloß weiterleitenden Zustand umgeschaltet werden können. Auf diese Weise kann aus der Messmodulkette eine beliebige Teilmenge von Messmodulen ausgewählt werden, deren Messwerte zur Gewinnung der entsprechenden Messgrößeninformation herangezogen werden, während die übrigen Messmodule lediglich die empfangene Messgrößeninformation unverändert weiterleiten. Dadurch können z.B. Minimalwerte und/oder Maximalwerte einer Messgröße für eine beliebige Teilmenge der Batteriezellen B₁, ..., Bₙ bestimmt werden.

Die auf die eine oder andere der oben erläuterte Art gewonnenen Messgrößeninformationen können dann in geeigneter Weise verwertet werden, insbesondere dazu, unerwünschte Zustände einzelner Batteriezellen zu erkennen und geeignete Gegenmaßnahmen zu ergreifen. Eine solche Maßnahme ist die Durchführung einer dissipativen Ladungsangleichung, d.h. zu unterschiedliche Ladezustände zwischen einzelnen Batteriezellen werden dadurch vermieden, dass Zellen mit zu hohem Ladezustand über einen elektrischen Widerstand ausreichend entladen werden. Dazu beinhaltet jedes Messmodul M₁, ..., Mₙ den entsprechenden Widerstand R, der zum Entladen der betreffenden Batteriezelle steuerbar parallel an diese angekoppelt werden kann, und eine zugehörige Endladesteuerschaltung 2. Sein Widerstandswert bestimmt sich primär aus der Differenz der Selbstentladungseigenschaften aller Batteriezellen B₁, ..., Bₙ und der Zeitdauer, innerhalb der ein maximaler Ladezustandsunterschied ausgeglichen werden soll. Eine untere Begrenzung des Widerstandswerts ist eventuell durch eine maximal erlaubte Erwärmung vor Ort gegeben. Der Verlust durch die dissipative Entladung trägt in Anwendungen mit hohem Ladungsdurchsatz bei Batterien mit kleiner Kapazität nur unwesentlich zu den üblichen, anderweitigen Verlusten bei und ist daher tolerierbar.

Damit das jeweilige Messmodul weiß, ob es seine zugehörige Batteriezelle entladen muss oder nicht, wird die zuvor ermittelte Information über den minimalen Spannungswert Uₘᵢₙ allen Messmodulen M₁, ..., Mₙ zur Verfügung gestellt, im Beispiel von Fig. 1 dadurch, dass sie vom letzten Messmodul Mₙ sukzessive an die übrigen Messmodule bis zum ersten Messmodul M₁ weitergeleitet wird. Jedes Messmodul M₁, ..., Mₙ vergleicht dann den minimalen Spannungswert Uₘᵢₙ mit dem eigenen gemessenen Spannungswert der zugeordneten Batteriezelle B₁, ..., Bₙ und aktiviert den dissipativen Entladevorgang, wenn der eigene Spannungswert um mehr als ein vorgegebener Abstand über dem minimalen Spannungswert Uₘᵢₙ liegt. Zur seriellen Übertragung des minimalen Spannungswertes Uₘᵢₙ kann in einer vorteilhaften Realisierung der ohnehin benötigte Triggerimpuls bzw. die Triggersignalverbindung TR_{H}, TR_{R} dienen. Als übertragenes Signal kann dem minimalen Spannungswert gleich der vorgebbare Abstandswert hinzuaddiert werden, der das Toleranzband repräsentiert, in welchem alle Zellenladezustände liegen sollen, so dass jedes Messmodul M₁, ..., Mₙ nur noch den eigenen Spannungsmesswert mit dem über die Triggerleitung TR_{H}, TR_{R} übermittelten minimalen Spannungswert Uₘᵢₙ vergleichen muss, um zu entscheiden, ob es eine dissipative Entladung seiner Zelle vornimmt.

Wenngleich die Erfindung oben anhand einer Batterie B erläutert wurde, versteht es sich, dass sie sich auch für andere herkömmliche elektrische Energiespeicher bzw. Energieerzeuger eignet, z.B. für einen Brennstoffzellenstapel eines Brennstoffzellensystems, das stationär oder mobil, z.B. in einem Brennstoffzellenfahrzeug, angeordnet sein kann.

## Patentansprüche

**1.** Elektronische Überwachungseinrichtung für einen aus mehreren hintereinandergeschalteten Speichereinheiten (B₁, ..., Bₙ) bestehenden elektrischen Energiespeicher (B), mit - den Speichereinheiten jeweils zugeordneten Messmodulen (M₁, ..., Mₙ), die wenigstens eine speicherzustandsindikative Messgröße an der zugeordneten Speichereinheit messen, wobei die Messmodule (M₁, ..., Mₙ) an eine serielle Signalverbindung (SV) angekoppelt sind,
**dadurch gekennzeichnet, dass**
- ein jeweils nächstes Messmodul vom vorhergehenden Messmodul eine von letzterem erzeugte Messgrößeninformation empfängt und eine eigene Messgrößeninformation durch Bewertung eines korrespondierend an der zugeordneten Speichereinheit gemessenen Messgrößenwertes mit der empfangenen Messgrößeninformation anhand eines vorgebbaren Bewertungskriteriums erzeugt und abgibt.

**2.** Elektronische Überwachungseinrichtung nach Anspruch 1, weiter
**dadurch gekennzeichnet, dass**
Mittel zum Umschalten der Messmodule (M₁, ..., Mₙ) zwischen einem aktivierten und einem deaktivierten Zustand durch ein Betriebsmodus-Steuersignal vorgesehen sind.

**3.** Elektronische Überwachungseinrichtung nach einem der Ansprüche 1 oder 2, weiter
**dadurch gekennzeichnet, dass** Mittel zur Umschaltung der Messmodule (M₁, ..., Mₙ) zwischen verschiedenen Bewertungsmodi durch ein Bewertungsmodus-Steuersignal vorgesehen sind.

**4.** Elektronische Überwachungseinrichtung nach einem der Ansprüche 1, 2 oder 3, weiter
**dadurch gekennzeichnet, dass**
Mittel zur selektiven Steuerung der Messmodule (M₁, ..., Mₙ) in einen voll aktiven oder in einen passiven, signalweiterleitenden Betriebszustand vorgesehen sind.

**5.** Elektronische Überwachungseinrichtung nach einem der Ansprüche 1 bis 4, weiter
**dadurch gekennzeichnet, dass**
die Messmodule (M₁, ..., Mₙ) zur Codierung der Messwerte in pulsweitenmodulierte Messsignale eingerichtet sind.

**5.** Elektronische Überwachungseinrichtung nach einem der Ansprüche 1 bis 4, weiter
**dadurch gekennzeichnet, dass**
die Messmodule (M₁, ..., Mₙ) zur Codierung der Messwerte in Pulssignale mit vom Messwert abhängiger Pulsverzögerung eingerichtet sind.

**6.** Elektronische Überwachungseinrichtung nach einem der Ansprüche 1 bis 4, weiter
**dadurch gekennzeichnet, dass**
die Messmodule (M₁, ..., Mₙ) zur Codierung der Messwerte in Konstantstrom-Messsignale mit messwertabhängiger Stromstärke eingerichtet sind.

**7.** Elektronische Überwachungseinrichtung nach einem der Ansprüche 1 bis 6, weiter
**dadurch gekennzeichnet, dass**
jedes Messmodul (M₁, ..., Mₙ) einen elektrischen Widerstand sowie Entlademittel zur steuerbaren, entladenden Ankopplung des Widerstands an die zugeordnete Speichereinheit aufweist.

## Claims

**1.** Electronic monitoring device for an electrical energy store (B) comprising a plurality of series-connected storage units (B₁, ..., Bₙ), having
- measurement modules (M₁, ..., Mₙ) which are associated with each of the storage units and measure at least one measurement variable, which is indicative of the storage state, at the associated storage unit, with the measurement modules (M₁, ..., Mₙ) being coupled to a serial signal connection (SV),
**characterized in that**
- a next measurement module in each case receives measurement variable information, which is produced by the previous measurement module, from the latter, and produces and emits its own measurement variable information by weighting of a measurement variable value, which is measured in a corresponding manner at the associated storage unit, with the received measurement variable information on the basis of a weighting criterion which can be predetermined.

**2.** Electronic monitoring device according to Claim 1, further
**characterized in that**
means are provided for switching the measurement modules (M₁, ..., Mₙ) between an activated state and deactivated state by means of an operating mode control signal.

**3.** Electronic monitoring device according to one of Claims 1 or 2, further
**characterized in that**
means are provided for switching the measurement modules (M₁, ..., Mₙ) between different weighting modes by means of a weighting mode control signal.

**4.** Electronic monitoring device according to one of Claims 1, 2 or 3, further
**characterized in that**
means are provided for selective control of the measurement modules (M₁, ..., Mₙ) to a fully active operating state or to a passive operating state in which signals are passed on.

**5.** Electronic monitoring device according to one of Claims 1 to 4, further
**characterized in that**
the measurement modules (M₁, ..., Mₙ) are designed to code the measured values into pulse-width-modulated measurement signals.

**5.** Electronic monitoring device according to one of Claims 1 to 4, further
**characterized in that**
the measurement modules (M₁, ..., Mₙ) are designed to code the measured values into pulsed signals with a pulse delay which is dependent on the measured value.

**6.** Electronic monitoring device according to one of Claims 1 to 4, further
**characterized in that**
the measurement modules (M₁, ..., Mₙ) are designed to code the measured values into constant current measurement signals with a current' level which is dependent on the measured value.

**7.** Electronic monitoring device according to one of Claims 1 to 6, further
**characterized in that**
each measurement module (M₁, ..., Mₙ) has an electrical resistance as well as discharge means for controllable, discharging coupling of the resistance to the associated storage unit.

## Revendications

**1.** Dispositif électronique de surveillance pour un accumulateur d'énergie électrique (B) constitué de plusieurs unités d'accumulation (B₁, ..., Bₙ) reliées en série, avec des modules de mesure (M₁, ..., Mₙ) qui sont respectivement associés aux unités d'accumulation et qui mesurent sur l'unité d'accumulation associée au moins un paramètre indicatif d'un état d'accumulation, sachant que les modules de mesure (M₁, ..., Mₙ) sont couplés à une liaison sérielle (SV) de signaux,
**caractérisé en ce que** chaque module de mesure suivant reçoit du module de mesure précédent une information de paramètre produite par ce dernier, et produit et délivre une propre information de paramètre par évaluation, au moyen de l'information de paramètre reçue et à l'aide d'un critère d'évaluation prescriptible, d'une valeur de paramètre mesurée d'une manière correspondante sur l'unité d'accumulation associée.

**2.** Dispositif électronique de surveillance selon la revendication 1, **caractérisé en outre en ce que** des moyens sont prévus pour commuter les modules de mesure (M₁, ..., Mₙ) entre un état activé et un état désactivé au moyen d'un signal de commande de mode d'exploitation.

**3.** Dispositif électronique de surveillance selon la revendication 1 ou 2, **caractérisé en outre en ce que** des moyens sont prévus pour commuter les modules de mesure (M₁, ..., Mₙ) entre différents modes d'évaluation au moyen d'un signal de commande de mode d'évaluation.

**4.** Dispositif électronique de surveillance selon l'une quelconque des revendications 1, 2 ou 3, **caractérisé en outre en ce que** des moyens sont prévus pour commander sélectivement les modules de mesure (M₁, ..., Mₙ) dans un état d'exploitation pleinement actif ou dans un état d'exploitation passif, de transmission de signaux.

**5.** Dispositif électronique de surveillance selon l'une quelconque des revendications 1 à 4, **caractérisé en outre en ce que** les modules de mesure (M₁, ..., Mₙ) sont conçus pour coder les valeurs mesurées en signaux de mesure à modulation de largeur d'impulsions.

**5.** Dispositif électronique de surveillance selon l'une quelconque des revendications 1 à 4, **caractérisé en outre en ce que** les modules de mesure (M₁, ..., Mₙ) sont conçus pour coder les valeurs mesurées en signaux d'impulsions avec une temporisation des impulsions fonction de la valeur mesurée.

**6.** Dispositif électronique de surveillance selon l'une quelconque des revendications 1 à 4, **caractérisé en outre en ce que** les modules de mesure (M₁, ..., Mₙ) sont conçus pour coder les valeurs mesurées en signaux de mesure à courant constant avec une intensité de courant fonction de la valeur mesurée.

**7.** Dispositif électronique de surveillance selon l'une quelconque des revendications 1 à 6, **caractérisé en outre en ce que** chaque module de mesure (M₁, ..., Mₙ) présente une résistance électrique ainsi que des moyens de décharge pour le couplage contrôlé de décharge de la résistance sur l'unité d'accumulation associée.
